(19)

Europäisches Patentamt

European Patent Office

Office européen des brevets

(11) **EP 3 084 344 B1**

(12) **EUROPÄISCHE PATENTSCHRIFT**

(45) Veröffentlichungstag und Bekanntmachung des Hinweises auf die Patenterteilung:
**12.07.2023 Patentblatt 2023/28**

(21) Anmeldenummer: **14820851.5**

(22) Anmeldetag: **19.12.2014**

(51) Internationale Patentklassifikation (IPC):
**G01B 9/02** (2022.01)   **G01B 9/021** (2006.01)
**G01M 11/02** (2006.01)

(52) Gemeinsame Patentklassifikation (CPC):
**G01B 9/02039; G01B 9/02085; G01B 9/021; G01M 11/005**

(86) Internationale Anmeldenummer:
**PCT/EP2014/078678**

(87) Internationale Veröffentlichungsnummer:
**WO 2015/091920 (25.06.2015 Gazette 2015/25)**

(54) **VERFAHREN ZUM VERMESSEN EINER SPHÄRISCH-ASTIGMATISCHEN OPTISCHEN FLÄCHE MIT FIZEAU INTERFEROMETRIE**

METHOD FOR MEASURING A SPHERICAL-ASTIGMATIC OPTICAL AREA

PROCÉDÉ POUR MESURER UNE SURFACE OPTIQUE SPHÉRIQUEMENT ASTIGMATE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **19.12.2013 DE 102013226668**

(43) Veröffentlichungstag der Anmeldung:
**26.10.2016 Patentblatt 2016/43**

(73) Patentinhaber: **Carl Zeiss SMT GmbH 73447 Oberkochen (DE)**

(72) Erfinder:
• **SCHULTE, Stefan**
  **73432 Aalen-Waldhausen (DE)**
• **SCHILLKE, Frank**
  **73434 Aalen (DE)**

(74) Vertreter: **Patentanwaltskanzlei WILHELM & BECK Prinzenstraße 13 80639 München (DE)**

(56) Entgegenhaltungen:
**WO-A2-2006/077145     DE-A1-102006 035 022**

**US-A1- 2004 051 857     US-A1- 2008 068 613**
**US-B1- 7 061 626**

• WIHARDJO E ED - DRIGGERS RONALD G: "INTERFEROMETRIC MEASUREMENT OF ACTUAL OBLIQUE ASTIGMATISM OF OPTHALMIC LENSES", OPTICAL ENGINEERING, SOC. OF PHOTO-OPTICAL INSTRUMENTATION ENGINEERS, BELLINGHAM, Bd. 34, Nr. 3, 1. März 1995 (1995-03-01), Seiten 785-789, XP000495223, ISSN: 0091-3286, DOI: 10.1117/12.190404

• JAN BURKE AND DAVID S WU: "Calibration of spherical reference surfaces for Fizeau interferometry: a comparative study of methods", APPLIED OPTICS, OPTICAL SOCIETY OF AMERICA, WASHINGTON, DC; US, Bd. 49, Nr. 31, 26. Oktober 2010 (2010-10-26), Seiten 6014-6023, XP001558364, ISSN: 0003-6935, DOI: 10.1364/AO.49.006014

• SONG WEIHONG ET AL: "Absolute calibration of a spherical reference surface for a Fizeau interferometer with the shift-rotation method of iterative algorithm", OPTICAL ENGINEERING, SOC. OF PHOTO-OPTICAL INSTRUMENTATION ENGINEERS, BELLINGHAM, Bd. 52, Nr. 3, 1. März 2013 (2013-03-01), Seite 33601, XP060025754, ISSN: 0091-3286, DOI: 10.1117/1.OE.52.3.033601 [gefunden am 2013-03-04]

EP 3 084 344 B1

**Beschreibung**

Die Erfindung betrifft ein Verfahren zum Vermessen einer sphärisch-astigmatischen optischen Fläche.

Diese Patentanmeldung beansprucht die Priorität der deutschen Patentanmeldung DE 10 2013 226 668.5.

Stand der Technik

Astigmatische optische Flächen und Freiformflächen mit gro-ßem astigmatischem Anteil können mithilfe eines computergenerierten Hologramms (CGH) interferometrisch geprüft werden, indem das CGH so ausgelegt wird, dass es eine Wellenfront erzeugt, die an jeder Position auf der Sollfläche senkrecht steht, so dass der Prüfling flächenhaft in Autokollimation vermessen wird.

Freiformflächen weisen im Unterschied zu rotationssymmetrischen Asphären allerdings keine Drehinvarianz auf, daher kann eine interferometrische Vermessung der Oberfläche im Allgemeinen nur in genau einer Relativposition zwischen CGH und Prüfling stattfinden. Dies bedeutet eine starke Einschränkung der Messgenauigkeit von Freiformflächen gegenüber rotationssymmetrischen Asphären, weil bei letzteren durch die Messung in theoretisch beliebig vielen Drehstellungen die nicht rotationssymmetrischen Fehlerbeiträge von Interferometer und Prüfling sauber getrennt werden können. Die erreichbare Passegenauigkeit liegt in diesem Fall bei ca. 20pm rms.

Bei Freiformflächen liegt die Passegenauigkeit hingegen aktuell nur bei ca. 1nm, da die Fehlerbeiträge des Interferometers, insbesondere die des CGHs, separat qualifiziert werden müssen. Dies ist nur mit einer solchen Genauigkeit für die einzelnen Parameter möglich, dass eine Gesamt-Messgenauigkeit im einstelligen Nanometerbereich erreicht wird. Einige der Parameter des CGHs sind Ätztiefe, Tastverhältnis, Trenching, Passe, Homogenität des CGH-Substrats, usw. Bei astigmatischen Flächen sind gegenüber Freiformflächen zudem zwei Drehstellungen des Interferometers möglich, nämlich 0° und 180°, weil der Astigmatismus eine zweizählige Drehinvarianz aufweist.

Nachteilig gibt es zurzeit keine Absolutkalibrierverfahren für Freiformflächen, wie sie zum Beispiel für sphärische Flächen existieren (z.B. Cateye-Kalibrierung, Drehschiebe-Verfahren, usw.).

Clemens Elster, "Exact two-dimensional wave-front reconstruction from lateral shearing interferograms with large shears", Applied Optics Vol. 39, No. 29, 10 October 2000 offenbart ein Verfahren zum Rekonstruieren bzw. Entfalten von Fehlern auf einer optischen Fläche, wobei eine Scherung zweier optischen Flächen zueinander gemessen wird, wonach aus den gescherten Wellenfronten durch Integration bzw. Entfaltung die ursprüngliche Wellenfrontform bzw. die Oberflächenform des Prüflings rekonstruiert wird.

Aus Wihardjo E. "Interferometric measurement of actual oblique astigmatism of ophthalmic lenses", Optical Engineering, Soc. of Photo-Optical Instrumentation Engineers, Bellingham, Bd. 34, Nr. 3, 1. März 1995, Seiten 785-789 ist ein Verfahren zur interferometrischen Vermessung von schiefem Astigmatismus von Linsen für Brillen bekannt. Zu diesem Zweck kommt ein Mach-Zehnder-Interferometer zum Einsatz. Eine zu vermessende Linse befindet sich in einem Arm des Interferometers, und ist auf einem Halter montiert. Mit Hilfe des Halters kann die Linse gedreht und innerhalb des Interferometerarms verschoben werden.

Die US 7 061 626 B1 betrifft ein Verfahren zum Herstellen eines optischen Elements mit einer asphärischen optischen Fläche. In dem Verfahren erfolgt eine Vermessung des optischen Elements unter Verwendung eines interferometrischen Systems. Das System umfasst eine Interferometeroptik mit einem Hologramm zum Formen eines Messlichtstrahls, so dass eine Wellenfront des Messlichtstrahls an eine Sollform der optischen Fläche angepasst ist. Beschrieben sind ferner Ausgestaltungen der Interferometeroptik, mit welchen der Messlichtstrahl um einen Winkel abgelenkt oder eine Symmetrieachse des aus dem Hologramm austretenden Messlichtstrahls in Bezug auf eine Symmetrieachse des auf das Hologramm einfallenden Messlichtstrahls verschoben werden kann.

Offenbarung der Erfindung

Es ist eine Aufgabe der vorliegenden Erfindung, ein verbessertes Verfahren zum Vermessen einer sphärisch-astigmatischen optischen Fläche bereitzustellen.

Insbesondere soll die optische Freiformfläche vom hier sogenannten sphärisch-astigmatischen Typ sein. Darunter wird hier verstanden, dass sich ihre Form als Überlagerung einer Kugelfläche und einer rein astigmatischen Fläche darstellen lässt, wobei diese Überlagerung als Addition der Pfeilhöhen der astigmatischen Fläche zu den Pfeilhöhen der Kugelfläche in Normalenrichtung verstanden wird.

Die Aufgabe wird gemäß einem ersten Aspekt der Erfindung gelöst mit einem Verfahren zum Vermessen einer sphärisch-astigmatischen optischen Fläche gemäß Anspruch 1.

Auf diese Weise kann mittels eines sogenannten Schiebe-Schiebe-Verfahrens eine sphärisch-astigmatische Fläche vermessen bzw. absolut kalibriert werden. Mittels eines Trennens der Fehler der Wellenfronterzeugungseinrichtung und der sphärisch-astigmatischen Fläche können die Wellenfrontformen der Wellenfronterzeugungseinrichtung und der sphärisch-astigmatische Fläche sehr exakt bestimmt werden. Vorzugsweise ist die sphärisch-astigmatische Fläche im Durchmesser nur geringfügig, insbesondere ca. 5 bis 10 % größer als die Wellenfronterzeugungseinrichtung.

Vorteile der Erfindung

Als besonders vorteilhaft wird angesehen, dass es mittels der Verfahren möglich ist, eine Absolutkalibrierung von im Wesentlichen rein sphärisch-astigmatischen Flächen und von sphärisch-astigmatischen Freiformflächen durchzuführen. Dadurch wird die Möglichkeit eröffnet, kalibrierte astigmatische Referenzflächen herzustellen, deren Form deutlich näher an einer Sollpasse von Freiformflächen liegt als eine rein sphärische Referenz, was dadurch begründet ist, dass der Hauptanteil von Freiformflächen häufig astigmatisch ist. Im Ergebnis ist es damit möglich, optische Freiformflächen nach vorgegebenen Spezifikationen hochgenau zu fertigen und zu prüfen bzw. zu kalibrieren.

Dies wird auch dadurch ermöglicht, dass bei einer Relativbewegung zwischen Prüfling und Prüfwellenfront vorteilhaft im von der Prüfvorrichtung erzeugten Interferogramm im Wesentlichen lediglich Verkippungen zwischen vom Prüfling reflektierter Wellenfront und der von einer Referenzfläche der Prüfvorrichtung reflektierten interferometrischen Referenzwellenfront beobachtet werden. Nach Justage dieser Verkippungen verbleibende Wellenfrontmeßwerte werden genau erhalten und ermöglichen einen genauen Rückschluss auf Abweichungen der Form der Freiformfläche von einer bestpassenden Sphäre.

Damit ermöglicht die Erfindung insbesondere eine Erweiterung eines Messspektrums von Subapertur-Interferometern. Es kann mithilfe der herstellbaren Anpassungselemente eine Vielzahl an Freiformflächen im mittel- bis hochfrequenten Ortsfrequenzspektrum gefertigt und geprüft werden. Prüfungen zum Zwecke einer Kalibrierung sind ebenfalls umfasst.

Vorteilhaft folgt aus der Erfindung die Möglichkeit zu einer vollflächigen Kalibrierung von Prüfaufbauten für sphärisch-astigmatische Flächen analog zur Drehschiebe-Kalibrierung von Sphären.

Die Erfindung wird im Folgenden mit weiteren Merkmalen und Vorteilen anhand von mehreren Figuren detailliert beschrieben. Dabei bilden alle beschriebenen oder dargestellten Merkmale für sich oder in beliebiger Kombination den Gegenstand der Erfindung, unabhängig von ihrer Zusammenfassung in den Patentansprüchen oder deren Rückbeziehung, sowie unabhängig von ihrer Formulierung bzw. Darstellung in der Beschreibung bzw. in den Figuren. Die Figuren sind vor allem dazu gedacht, die erfindungswesentlichen Prinzipien zu verdeutlichen und sind nicht notwendigerweise maßstabsgetreu dargestellt. In den Figuren haben gleiche oder funktionsgleiche Elemente gleiche Bezugsziffern.

In den Figuren zeigt:

Fig. 1     eine prinzipielle Darstellung einer Unterteilung einer zu prüfenden Freiformfläche in Subaperturen;

Fig. 2     eine prinzipielle Darstellung eines Trennens von Fehlerbeiträgen von Prüflingswellenfront und Referenzwellenfront;

Fig. 3     eine prinzipielle Darstellung eines Erkennens einer Fehlerart des Prüflings mittels des erfindungsgemäßen Verfahrens;

Fig. 4     eine Prüfoptik zur Prüfung einer sphärisch-astigmatischen Oberfläche;

Fig. 5     eine prinzipielle Darstellung einer Prüfvorrichtung, bestehend aus einer Vorrichtung, die die sphärisch-astigmatische Prüfwellenfront erzeugt und einem reflektierendem Kalibrier-CGH zur Absolutkalibrierung der Prüfwellenfront;

Fig. 6a     eine Querschnittsansicht eines refraktiven Fizeauelements;

Fig. 6b     eine Querschnittsansicht durch ein CGH-Fizeauelement;

Fig. 7     eine prinzipielle Schnittansicht durch ein EUVL-Projektionsobjektiv; und

Fig. 8     ein prinzipielles Ablaufdiagramm einer Ausführungsform des erfindungsgemäßen Verfahrens zum Vermessen einer optischen Freiformfläche.

Ausführungsformen der Erfindung

Die Erfindung stellt im Prinzip eine Erweiterung eines für sphärische Flächen bekannten Drehschiebe-Verfahrens dar. Eine sphärische Fläche ist invariant gegenüber Drehungen um die Flächennormale und einer beliebigen Verkugelung um ihren Radiusmittelpunkt.

Analog dazu ist eine sphärisch-astigmatische Fläche nahezu invariant gegenüber einer beliebigen Kombination von Verkugelungen in Richtung der beiden "Achsen" des Astigmatismus der Fläche, wobei jede Teilverkugelung um den in der entsprechenden Achse gültigen Radienmittelpunkt erfolgen muss.

Die genannten Gegebenheiten einer sphärisch-astigmatischen Fläche kann man nunmehr ausnutzen, um eine interferometrisch zu prüfende sphärisch-astigmatische Fläche gegen eine astigmatische Referenzwellenfront makroskopisch in beliebige Richtungen zu verschieben bzw. zu verkugeln, wodurch auswertbare Interferogramme mit hinreichend kleinen Wellenfrontgradienten erzeugt und mathematisch ausgewertet werden können. Durch die zueinander verschobenen Wellenfronten ist es möglich, die Fehlerbeiträge von Prüflings- und Referenzwelle zu trennen und somit eine Absolutkalibrierung der gesamten Freiformfläche zu erreichen. Auf diese Weise können Interferometerfehler von Prüflingsfehlern getrennt werden, wodurch ermittelt werden kann, welche Fehler dem Prüfling und welche Fehler dem Interferometer zugerechnet werden können. Dabei sind astigmatische Deformationen bis in den Millimeter-Bereich denkbar.

Bei einer beispielsweise rotationssymmetrischen Asphäre führt im Allgemeinen eine Verkugelung von wenigen 10 $\mu$m zu derart großen Wellenfrontgradienten, dass das Interferogramm nicht mehr auswertbar ist. Bei sphärisch-astigmatischen Flächen ergibt sich hier ein sogenannter Dämpfungsfaktor von ca. 1000 bei Asphärizitäten bis zu 1 mm. Das Grundprinzip der Verkugelbarkeit astigmatischer Flächen gegeneinander ist, dass die Scherung von Astigmatismus gegen sich selbst eine Kippung ergibt, die größtenteils durch eine Kippung der Elemente gegeneinander kompensiert werden kann, wodurch sich die obengenannte Dämpfung ergibt.

Die Rekonstruktion der Prüflingswellenfront kann nun durch eine mittels bekannter Verfahren durchgeführte mathematische Trennung der in jedem Interferogramm konstanten Anteile (Interferometerfehler) und dem mit dem Prüfling "mitschiebenden" Anteil erfolgen.

Eine weitere Erhöhung der Genauigkeit kann über die 180° Rotationsinvarianz von astigmatischen Flächen erreicht werden. Man kann deshalb die gesamte Verschiebeprozedur in einer zweiten um 180° verdrehten Drehstellung der Flächen zueinander wiederholen, um auf diese Weise eine bessere Mittelung bzw. Konsistenz der Messungen zu erzielen.

Bei herkömmlichen Drehschiebe-Verfahren können nur nahezu sphärische Flächen absolut kalibriert werden. Die Absolutkalibrierung von rotationssymmetrischen Asphären bezieht sich nur auf den nicht-rotationssymmetrischen Anteil der Fläche bzw. der Prüfoptik, der rotationssymmetrische Anteil wird über eine Qualifizierung (d.h. eine einmalig nicht im Prüfaufbau ("extern") durchgeführte Bestimmung von Fehlerbeiträgen der Prüfoptik), und nicht über eine Kalibrierung bestimmt.

Erfindungsgemäß ist es möglich, eine nahezu vollständige Absolutkalibrierung einer ganzen Klasse von asphärischen Flächen durchzuführen, nämlich solcher asphärischen Flächen, welche sphärisch-astigmatischen Charakter haben. Erforderlich ist dazu eine sphärisch-astigmatische Wellenfront, die zum Beispiel mittels eines CGHs in einem Interferometer erzeugt wird, oder mittels einer sphärisch-astigmatischen Referenzfläche, wobei diese an die zu prüfende Freiformfläche ("Prüfling") grob angepasst sein sollte. Passefehler des Prüflings sollten durch einen Vorbearbeitungsprozess derart klein sein, dass sie gegen die generierte sphärisch-astigmatische Prüfwellenfront interferometrisch messbar sind.

Eine sphärisch-astigmatische Wellenfront im Sinne der Erfindung ist eine Wellenfront, die mittels einer Addition der Pfeilhöhen einer Kugelwelle mit denen einer astigmatischen Welle generiert wird.

Vorgesehen ist eine Vorrichtung, um den Prüfling um seinen jeweiligen (x- und y-) Radiusmittelpunkt makroskopisch in beliebiger Richtung zu verkugeln, bevorzugt um wenigstens ca. 10 %, noch mehr bevorzugt um ca. 50 % seines Durchmessers. Weiterhin sollte der Prüfling in allen Freiheitsgraden, insbesondere Kippung und Azimut, fein justierbar sein, d.h. im um- bzw. im $\mu$rad-Bereich.

Die derart beschriebene "Schiebe-Schiebe"-Kalibrierung kann, wie oben erwähnt, unter 180° Rotation des Prüflings zur Referenz wiederholt werden.

Der Betrag der Verkugelung kann variiert werden, es sollte jedoch mindestens um ca. 5% des Prüflingsdurchmessers geschert bzw. geschoben werden, um eine hinreichend gute Trennung zwischen Prüflings- und Referenzwellenfront zu erreichen.

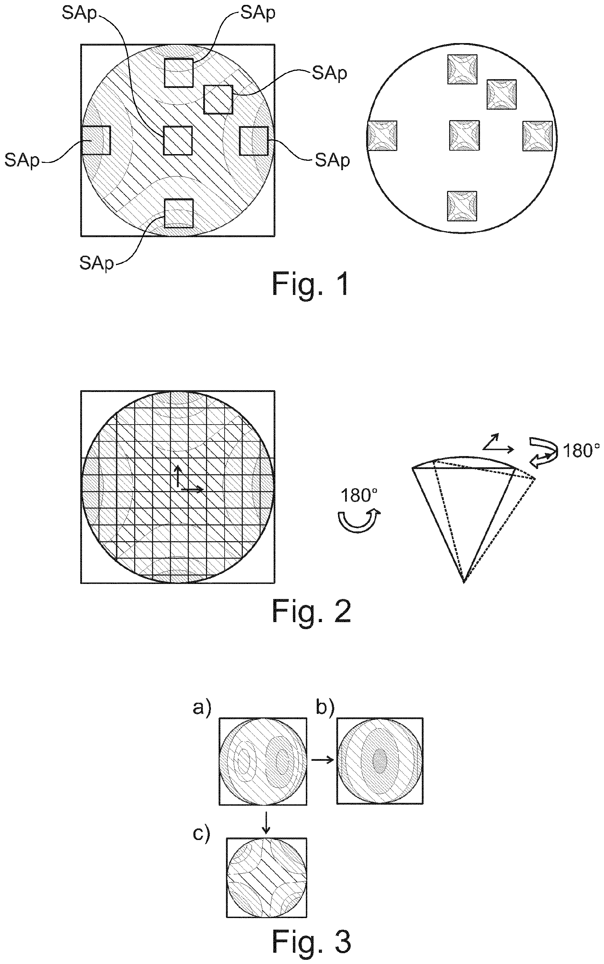

Fig. 1 zeigt sechs Subaperturen SAp einer sphärisch-astigmatischen Fläche, die alle im Wesentlichen die gleiche Deformation aufweisen. Dies ermöglicht eine Absolutkalibrierung, indem man zwei sphärisch-astigmatische Flächen gegeneinander verschiebt/verkugelt, die Interferogrammphasen bestimmt und über ein mathematisches Rekonstruktionsverfahren die Wellenfrontbeiträge von Prüflingswellenfront und Referenzwellenfront trennt. Dazu ist ein hinreichend großer Satz an Phasenbildern von verschiedenen Relativpositionen erforderlich.

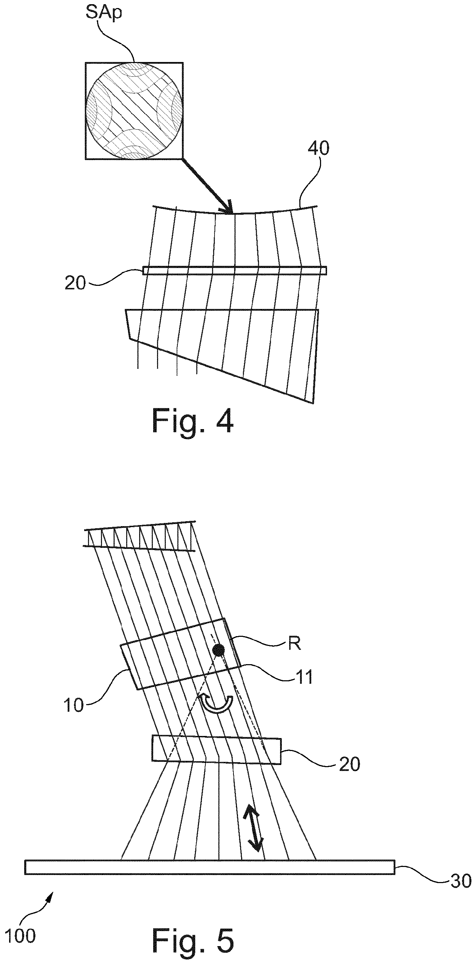

Die Skalen in den Subaperturen SAp zeigen linear verlaufende Grauabstufungen, die das Höhenprofil eines Prüflings repräsentieren. Jede Subapertur SAp ist mit einer anderen lokalen Kippung beaufschlagt. Beim Anmessen jeder einzelnen Subapertur SAp kann durch Verkippen des Prüflings oder des Interferometers quasi der gleiche astigmatische Phasenverlauf erzeugt werden, wie im Kreis rechts dargestellt. Da in jeder Subapertur SAp der Astigmatismus ähnlich ist, kann dieser in der Wellenfronterzeugungseinrichtung vorgehalten werden. Die Grundkrümmung der Fläche erscheint nicht im Interferogramm, weil, wie in Fig. 5 dargestellt, der Prüfstrahlengang angepasst divergent verläuft.

Nachgekippt wird der Prüfling oder das Interferometer somit zum Zwecke eines Minimierens des Phasengradienten im Interferogramm der jeweiligen Subapertur SAp. Der allen Subaperturen SAp gemeinsame Deformationsanteil kann nun als konstanter Anteil in die Prüfoptik (Kompensationssystem) eingeführt werden, so dass dieser immer gleiche Phasengradient aus den Interferogrammen der einzelnen Subaperturen SAp verschwindet, womit die Messdynamik deutlich erhöht wird. Die dargestellten sechs Subaperturen SAp sind selbstverständlich lediglich beispielhaft zu sehen, wobei in der Praxis Prüflinge mit bis zu ca. 1000 Subaperturen kalibriert werden.

Fig. 2 soll andeuten, dass die Subaperturen SAp in x- und y-Richtung gegeneinander verschoben und/oder verkugelt und um 180° gegeneinander verdreht werden können, um die Fehlerbeiträge von Prüflingswellenfront und Referenzwellenfront voneinander zu trennen. Es wird also einerseits eine Verschiebung durchgeführt, wodurch vorteilhaft nur kleine Änderungen der idealen Wellenfront resultieren. Zusätzlich kann der Prüfling auch um 180° rotiert bzw. verdreht werden, wobei diese Verdrehung eine zusätzliche Möglichkeit darstellt, um Fehler des Prüflings 40 besser getrennt zu erfassen. Vorteilhaft wird auf diese Weise ein zusätzlicher Freiheitsgrad in der Relativbewegung zwischen dem Prüfling und der Referenzwellenfront bereitgestellt.

Die rechte Darstellung von Fig. 2 deutet alle im Gesamtsystem einstellbaren Freiheitsgrade (Verdrehung/ Verschiebung/Verkugelung) an, ohne dass dadurch das Interferogramm unbrauchbar wird. Insbesondere kann um einen Radiusmittelpunkt verkugelt oder der Prüfling um 180° verdreht werden, wobei in allen diesen Fällen eine Wellenfront im Wesentlichen senkrecht auf den Prüfling trifft.

Auf diese Weise können vorteilhaft Relativmessungen durchgeführt und die Interferometerwellenfront von der Prüflingswellenfront getrennt werden. Im Ergebnis bleiben Interferometerfehler "somit stehen" und Prüflingsfehler "bewegen sich mit", wobei diese Fehler dann rechnerisch mittels eines mathematischen Rekonstruktionsverfahrens voneinander getrennt werden können.

Fig. 2 verdeutlicht somit, dass die sphärisch-astigmatische Wellenfront und Teilbereiche des Prüflings gegeneinander verschoben und um 180° gedreht werden können, ohne dass die Wellenfronten merklich geändert werden.

Fig. 3 zeigt beispielhaft einen erfindungsgemäß detektierbaren bzw. kalibrierbaren Fehler eines Prüflings in Form einer Koma. Fig. 3 zeigt in den Darstellungen b) und c) Scherwellenfronten (Ableitungen) einer in Fig. 3a dargestellten Koma auf der Prüflingswellenfront. Darstellung b) zeigt prinzipiell eine Kombination aus Fokus und Astigmatismus, wenn die Koma gegen sich selbst geschert bzw. verschoben wird. Die Scherterme resultieren dabei teilweise in Justageanteilen. Diese können durch 180° Drehung erfindungsgemäß eindeutig von tatsächlich vorhandenen Prüflingsdeformationen getrennt werden. Die Figur soll somit andeuten, welche Fehlerbeiträge man durch eine 180° Drehung der Prüfoptik erkennen kann. Wenn auf dem Prüfling eine Koma vorhanden ist und der Prüfling um 180° gedreht wird, dreht sich im Ergebnis die Koma mit, wie in Darstellung c) erkennbar ist.

Im Fall einer geradzahligen Aberration, wie z.B. 4-Welligkeit, 6-Welligkeit, etc. würde das nicht funktionieren, weil sich diese aufgrund ihrer Invarianz gegenüber 180° Drehungen nicht mitdreht.

Fig. 4 zeigt, dass die Absolutkalibrierung einer astigmatischen Fläche zum Beispiel auf einem "Verkugelungs-Mount" durchgeführt werden kann, indem der Prüfling in verschiedenen, durch Verkugelung bewirkten "Schiebepositionen" relativ zur vom CGH erzeugten Referenzwellenfront gemessen wird. Anschließend wird die Absolutwellenfront des Prüflings durch mathematische Rekonstruktion ermittelt.

Fig. 4 zeigt ein Anpassungselement 20, z.B. in Form eines CGHs, welches die eigentliche Referenz- bzw. Prüfwelle erzeugt. Ein unterhalb des Anpassungselements 20 angeordnetes Prisma stellt eine Hilfsfunktion für eine Prüfoptik bereit, indem es einen vertikalen Parallelstrahl aus dem Interferometer derart umlenkt, dass dieser schräg auf das Anpassungselement 20 einfällt.

Eine Planwelle trifft von unten kommend auf das Anpassungselement 20, wodurch das Anpassungselement 20 eine sphärisch-astigmatische Wellenfront erzeugt. Die schwarze gekrümmte Linie deutet einen Abschnitt eines Prüflings 40 mit einer Subapertur SAp an.

Der Prüfling 40 wird vorzugsweise auf eine Halterung (nicht dargestellt) montiert, auf der er um seinen Radiusmittelpunkt in x- und y-Richtung verkugelt und um 180° verdreht werden kann. Das ist deshalb möglich, weil das Anpassungselement 20 im Wesentlichen eine Wellenfront erzeugt, die einer Oberflächengestaltung des Prüflings 40 entspricht. Sehr günstig ist es, dass mittels des Anpassungselements 20 eine rein sphärisch-astigmatische Wellenfront erzeugt wird. Im Prinzip deutet Fig. 4 also an, dass zur Prüfung einer Freiformfläche eine bestmögliche Anpassung der sphärisch-astigmatischen Referenzwellenfront an die Freiformfläche vorzusehen ist.

Fig. 5 zeigt eine Ausgestaltung der Prüfvorrichtung. Erkennbar ist eine Prüfvorrichtung 100 mit einem Fizeauelement 10 mit einer im Wesentlichen planen Referenzfläche 11. Ferner sind ein Anpassungselement 20 (astigmatisches CGH) und ein Kalibrierelement 30 (Kalibrier-CGH) in Reflexion vorgesehen. Für eine Absolutkalibrierung der astigmatischen Wellenfront des Anpassungselements 20 kann mittels eines Sensorkopfes (nicht dargestellt) der Kalibriermaschine die Wellenfront des Anpassungselements 20 gegen das Kalibrierelement 30 beliebig verkugelt werden. Das Kalibrierelement 30 ist derart ausgelegt, dass es die Welle in sich selbst (in Autokollimation) zurückwirft, wenn diese ihre Sollform hat.

Bei der eigentlichen Vermessung der Oberfläche des Prüflings 40 (nicht dargestellt in Fig. 5) ist dann das Kalibrierelement 30 gegen den Prüfling in Form der Freiformfläche auszutauschen. Erkennbar ist, dass ein Radiusmittelpunkt R einer Grundsphäre innerhalb der Wellenfronterzeugungseinrichtung 10 angeordnet ist, was jedoch von der zu erzeugenden Wellenfrontform abhängt, so dass dieser durchaus auch außerhalb der Wellenfronterzeugungseinrichtung 10 angeordnet sein könnte. Der unterste Abschnitt des Strahlengangs, der mit einem Doppelpfeil hervorgehoben ist, repräsentiert die Prüfwelle.

In der Praxis ist vorgesehen, dass die Prüfoptik, aufweisend das Fizeauelement 10 mit der Referenzfläche 11 und einem Anpassungselement 20 in Form eines CGHs gekippt wird, wobei ein beweglicher interferometrischer Sensor (nicht dargestellt) relativ zum Prüfling 40 vorgesehen ist. Ziel ist dabei jedesmal, die Wellenfront möglichst senkrecht bzw. im Wesentlichen senkrecht auf den Prüfling 40 auftreffen zu lassen.

Im Wesentlichen senkrecht bedeutet in diesem Zusammenhang, dass ein interferometrisches Messen der sphärisch-astigmatischen Fläche bzw. der Freiformfläche mit erforderlicher Genauigkeit möglich sein muss, wobei dies auch bei nicht exakt senkrechtem Einfall der Prüfwellenfront auf die sphärisch-astigmatische Fläche bzw. Freiformfläche erreicht werden kann. Es hat sich herausgestellt, dass eine maximal zulässige Abweichung von der Normalen im einstelligen mrad-Bereich liegen, insbesondere max. 5 mrad, insbesondere max. 2 mrad, insbesondere max. 1 mrad betragen kann. Dieses Erfordernis gilt für jede einzelne der zu messenden Subaperturen SAp.

Im Folgenden wird im Detail ein Ablauf eines erfindungsgemäßen Herstellungsprozesses für eine sphärisch-astigmatische Freiformfläche beschrieben, wobei eine Voraussetzung für das Funktionieren des Herstellungsverfahrens ist, dass wenigstens 80% einer Abweichung der Freiformfläche von einer bestpassenden Sphäre astigmatisch ist.

Zur Bestimmung der bestangepassten ("bestpassenden") kugelsymmetrischen Oberfläche kann beispielsweise als Kriterium die mittlere quadratische Abweichung ("rms-Wert") der asphärischen Oberfläche von der zu vergleichenden kugelsymmetrischen Oberfläche in einer vorgegebenen Richtung minimiert werden. Ein alternatives Kriterium zur Bestimmung der bestangepassten kugelsymmetrischen Oberfläche umfasst den Peak-to-Valley Wert ("PV-Wert"), der einen Abstand zwischen einem höchstgelegenen und einem tiefstgelegenen Punkt der Freiformfläche abzüglich der kugelsymmetrischen Fläche repräsentiert. Das sinnvollste Kriterium ist, die Sphäre so zu wählen, dass das Maximum des (Betrages des) Gradienten der Differenz zwischen Freiformfläche und anzupassender Sphäre minimal wird.

Eine bestangepasste bzw. bestpassende Sphäre ist somit eine kugelsymmetrische Form, deren Abweichung von der Gesamtform der Freiformfläche minimal ist.

Vorzugweise wird die gesamte Freiformfläche derart in einzelne Subaperturen SAp aufgeteilt, dass dadurch ein Restgradient innerhalb jeder einzelnen Subapertur SAp vorzugsweise kleiner als ca. 2 mrad ist. Dieser Restgradient bezieht sich auf die relativen Winkel der Flächennormalen zueinander. In der Praxis kann dies beispielsweise bedeuten, dass ein Kreis der Subapertur SAp einen Durchmesser von ca. 10 mm aufweist, weil bei einer größeren Subapertur SAp nicht mehr sinnvoll gemessen werden kann.

Zunächst wird für die optische Freiformfläche ein Designprozess durchgeführt, beispielsweise für einen abbildenden Spiegel eines EUVL-Objektivs (engl. extreme ultra violet lithography). Insbesondere wird für die Freiformfläche der bestpassende Radius (engl. Best-Fit Radius) und Astigmatismus für einen Kalibrierprozess bestimmt.

Danach wird ein sphärisch-astigmatisches Fizeauelement ausgelegt, wobei eine Anpassung der beiden Radien des durch das Fizeauelement erzeugten Astigmatismus in zueinander orthogonalen Schnittebenen unter Berücksichtigung eines angestrebten Arbeitsabstandes des Fizeauelements zur Freiformfläche erfolgt. Der genannte Arbeitsabstand ist ein Sollabstand zwischen der Wellenfronterzeugungseinrichtung 10 und der Freiformfläche während der durchzuführenden Messung.

Danach erfolgt eine Herstellung des Fizeauelements und einer passenden Gegenfläche (Kalibrierfläche) mit einem vorzugsweise mindestens ca. 5% größeren Durchmesser als der Durchmesser des Fizeauelements, gegebenenfalls mit Hilfe eines Prüf-CGHs.

Anschließend erfolgt eine Absolutkalibrierung der Wellenfront des Fizeauelements durch die oben beschriebene Schiebe-Schiebe-Kalibrierung, gegebenenfalls unter Verwendung einer 180°-Drehung gegen die genannte ausschließlich sphärisch-astigmatische Gegenfläche und gegebenenfalls eine iterative Korrektur einer oder beider Wellenfronten.

Es erfolgt danach ein Einbau des derart hergestellten Fizeauelements in einen beweglichen interferometrischen Sensor sowie eine Justage des Sensors. Ein derartiger Sensor, mit dem Teilabschnitte der Freiformfläche vermessen werden können, ist beispielsweise aus US 2012/ 0229814 A1 oder DE 10229816 A1 bekannt, deren Offenbarungen hier vollumfänglich mit aufgenommen werden.

Danach wird eine Bahnkurve für den interferometrischen Sensor relativ zur zu prüfenden Freiformfläche für eine flächendeckende Messung von Subaperturen SAp programmiert. Es erfolgt ein Einlegen und ein Justieren der zu prüfenden Freiformfläche in die Messapparatur mit dem interferometrischen Sensor. Dadurch wird ein automatisiertes Abfahren der programmierten Bahnkurve sowie ein Aufnehmen von Interferenzbildern, sowie daraus ein Berechnen und Abspeichern von Oberflächentopographiebildern der einzelnen Subaperturen SAp ermöglicht. Vorzugsweise überlappen sich die einzelnen Subaperturen SAp zumindest derart, dass eine Vereinigungsmenge aller Subaperturen SAp eine Obermenge der gesamten Freiformfläche ergibt.

Es wird sodann eine Oberflächenform des Prüflings in den einzelnen Subaperturen SAp unter Berücksichtigung der mittels der oben beschriebenen Absolutkalibrierung erhaltenen Form (Radius, Astigmatismus, Restpasse) des Fizeauelements berechnet.

Danach erfolgt eine Transformation der Subaperturkoordinaten in ein Koordinatensystem der Freiformfläche, weil das Messen von einzelnen Abschnitten der Fläche in einem lokalen Koordinatensystem durchgeführt worden ist. Schließlich erfolgt ein Zusammensetzen (engl. stitching) der Freiformfläche aus den einzelnen Subaperturen SAp zu einer Gesamtfläche.

Im Ergebnis ist jetzt ein Pfeilhöhen- bzw. ein Peak-to-Valley- bzw. ein PV-Wert der Freiformfläche auf der gesamten Oberfläche bekannt.

Es wird nunmehr die zu Beginn ausgelegte Sollform der Freiformfläche von der tatsächlichen Form der Freiformfläche subtrahiert, wobei eine Bewertung der Abweichung der Istform von der Sollform durchgeführt wird, danach wird die Freiformfläche gegebenenfalls entsprechend der bestimmten Abweichung von der Sollform nachbearbeitet.

Der ganze vorangehend beschriebene Prozess wird nunmehr iterativ solange durchgeführt, bis mittels formgebender Bearbeitungsschritte und Messloops erreicht wird, dass die Form der Freiformfläche innerhalb der geforderten Spezifikation ist.

Im Ergebnis lässt sich mit dem beschriebenen Verfahren eine Freiformfläche herstellen, die im mittel- bis hochfrequenten Bereich sehr genau herstell- und prüfbar ist, vorzugsweise im pm-Bereich für Pfeilhöhenverlauf, PV- oder rms-Wert.

Aus US 7,538,856 B2 und US 7,355,678 B2 sind EUVL-Projektionsobjektive bekannt, deren Spiegel mittels des erfindungsgemäßen Verfahrens prüf- und herstellbar sind. Insbesondere ist das Verfahren für alle dort gezeigten Spiegel sinnvoll, weil alle genannten Spiegel abgesehen von einer Grundkrümmung vorwiegend astigmatisch ausgebildet sind.

Prinzipiell sind zwei verschiedene Arten von Fizeauelementen denkbar:

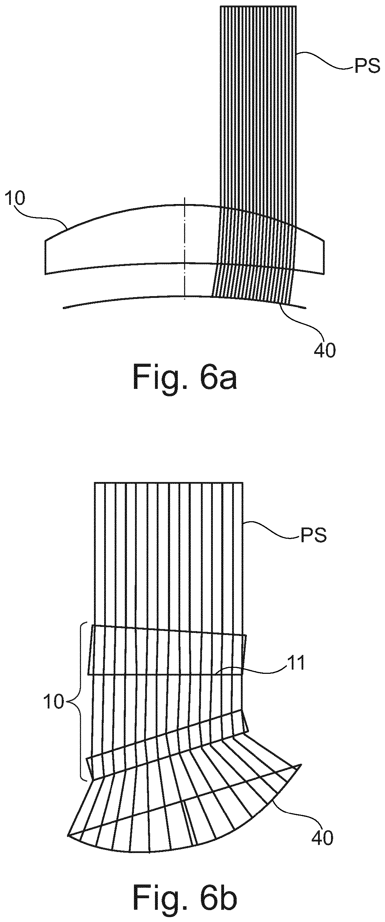

Fig. 6a zeigt einen Querschnitt durch ein refraktives Fizeauelement, bei dem durch eine Brechung eines Parallelstrahls PS an der Rückseite im Glas des Fizeauelements eine sphärisch-astigmatische Welle entsteht, die an jedem Punkt der sphärisch-astigmatischen Vorderseite des Glases senkrecht steht. Die durch das Glas durchtretende Welle ist damit ebenfalls sphärisch-astigmatisch und über einen definierten Arbeitsabstand an eine zu prüfende sphärisch-astigmatische Fläche bzw. Freiformfläche (Prüfling 40) bestmöglich angepasst.

Fig. 6b zeigt eine Querschnittsansicht durch ein CGH-Fizeauelement mit einer Kombination aus Fizeauplatte (mit planer Referenzfläche 11 des Interferometers) und dem CGH. Das CGH erzeugt eine sphärisch-astigmatische Welle, die über einen definierten Arbeitsabstand an einen zu prüfenden Prüfling 40 in Form einer sphärisch astigmatischen Fläche bzw. einer Freiformfläche bestmöglich angepasst ist, wodurch ein möglichst senkrechter Einfall auf die Prüffläche des Prüflings 40 generiert wird.

Beide Typen von Fizeauelementen können mithilfe einer angepassten rein sphärisch-astigmatischen Prüffläche oder mit einem entsprechenden Kalibrier-CGH mit dem beschriebenen Schiebe-Schiebeverfahren absolut kalibriert werden.

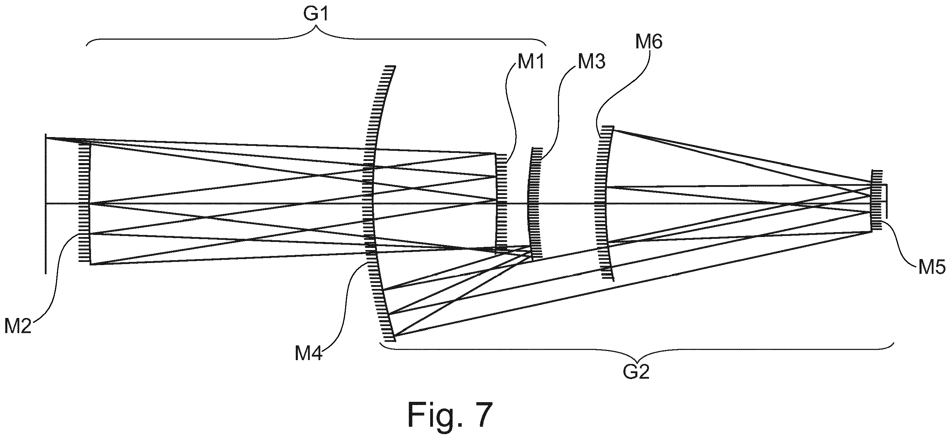

Fig. 7 zeigt eine bekannte prinzipielle Ansicht eines Linsenschnitts eines EUVL-Projektionsobjektivs mit einer ersten optischen Baugruppe G1 mit Spiegeln M1 und M2 sowie mit einer zweiten optischen Baugruppe G2 mit Spiegeln M3 bis M6. Insbesondere die Spiegel M5 und M6 sind als Freiformflächen ausgebildet, deren astigmatischer Anteil einer Abweichung von einer bestangepassten Sphäre wenigstens ca. 80% und in einer besonders bevorzugten Ausgestaltung wenigstens ca. 90% beträgt. Denkbar sind auch EUVL-Projektionsobjektive mit acht Spiegeln, von denen wenigstens ein Spiegel als Freiformfläche ausgebildet ist (nicht dargestellt).

Betreffend den ca. 80% bis ca. 90ö-Anteil an der Gesamtabweichung der Prüflingspasse von der sphärischen Grundform sind mehrere relevante Größen zu beachten:

(i) PV oder rms der Abweichung der Freiformfläche von der sphärischen Grundform (= PV(FFF) bzw. rms(FFF))

(ii) PV oder rms des astigmatischen Anteils der Freiformfläche, zum Beispiel bestimmbar über den Fit von Zernike-Polynomen an die mathematische Flächenbeschreibung (= PV(Ast) bzw. rms(Ast)

(iii) PV oder rms der Abweichung (i) nach Subtraktion des astigmatischen Anteils (ii) (= PV(Rest) bzw. rms(Rest)).

Die rms-Werte addieren, bzw. subtrahieren sich ungefähr quadratisch, da die mittels zweidimensionaler Polynome beschreibbaren Abweichungen von der sphärischen Grundform (hier zum einen "Astigmatismus", zum anderen der verbleibende Restfehler) linear unabhängig sind, d.h. dass gilt:

$$rms(FFF) = SQRT(rms(Ast)^2 + rms(Rest^2)$$

Daraus folgt:

$$rms(Ast) = SQRT(rms(FFF)^2 - rms(Rest)^2)$$

Mit folgenden Abkürzungen:

SQRT     Quadratwurzel
PV     Peak-to-Valley-Wert
rms     Root-Mean-Square-Wert
FFF     Freiformfläche
Rest     Restfehler

Für zum Beispiel mindestens 80% als sphärisch-astigmatischen Anteil an der Gesamtabweichung von der sphärischen Grundform kann man folgende Definition angeben:

$$rms(Rest)/rms(FFF) < 0,2 \ (= 100\% - 80\%)$$

In Worten ausgedrückt bedeutet dies, dass der PV- oder rms-Wert der Abweichung der Freiformfläche von der Kugelform abzüglich des astigmatischen Anteils, normiert auf den PV-oder rms-Wert der Gesamtabweichung der Freiformfläche von der Kugelform kleiner als ca. 20% sein soll.

Sämtliche vorgenannten mathematischen Beziehungen können statt des angeführten rms-Werts auch den PV-Wert beinhalten, wobei die Beziehungen für den PV-Wert nur näherungsweise, bzw. im Mittel gelten.

Mithilfe des erfindungsgemäßen Verfahrens lassen sich Freiformflächen herstellen und prüfen, deren astigmatischer Anteil an einer Gesamtabweichung der Freiformfläche von einer bestangepassten Sphäre typischerweise zwischen ca. 0,5mm und ca. 20mm PV-Wert beträgt. Dabei kann ein Grundradius der bestangepassten Sphäre zwischen ca. ≥ 300mm und ca. Unendlich (∞) ausgebildet sein. Der Radius Unendlich (∞) entspricht dabei einer Planfläche.

Insbesondere lässt sich mit dem Verfahren eine Freiformfläche herstellen und prüfen, deren lokaler Gradientenverlauf in einer beliebigen Subapertur SAp, die als ein Kreis mit einem Durchmesser von wenigstens ca. 10mm ausgebildet ist, nach Subtraktion einer Kippung, eines Fokus einer Prüfwelle und eines für den gesamten Spiegel konstanten rein astigmatischen Anteils maximal ca. 2 mrad PV beträgt.

Insbesondere lässt sich mit dem erfindungsgemäßen Verfahren eine Freiformfläche herstellen und prüfen, deren Abweichung von der Sollform in einem Ortswellenlängenband zwischen ca. 0,05mm und ca. 50mm Ortswellenlänge maximal ca. 100pm bis ca. 200pm, vorzugsweise maximal ca. 50pm bis 100pm, noch mehr bevorzugt maximal ca. 20pm beträgt.

Insbesondere lässt sich mit dem erfindungsgemäßen Verfahren eine Freiformfläche herstellen und prüfen, deren Abweichung von der Sollform im Ortswellenlängenband zwischen ca. 0,1mm und ca. 30mm Ortswellenlänge maximal ca. 100pm bis ca. 200pm, vorzugsweise maximal ca. 50pm bis 100pm, noch mehr bevorzugt maximal ca. 20pm beträgt.

Zusätzlich sind mittels des erfindungsgemäßen Verfahrens rein sphärisch-astigmatische Flächen nach Abzug von Fokus und Astigmatismus mit einer Genauigkeit von ca. 20pm prüfbar.

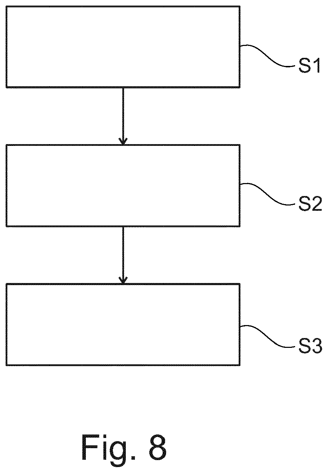

Fig. 8 zeigt ein prinzipielles Ablaufdiagramm einer Ausführungsform des erfindungsgemäßen Verfahrens zum Vermessen einer sphärisch-astigmatischen Fläche.

In einem ersten Schritt S1 wird ein Generieren einer sphärisch-astigmatischen Wellenfront als Prüfwellenfront mittels einer Wellenfronterzeugungseinrichtung 10 durchgeführt.

In einem zweiten Schritt S2 erfolgt ein interferometrisches Vermessen von Wellenfrontdifferenzen zwischen der Wellenfronterzeugungseinrichtung und der an die Wellenfronterzeugungseinrichtung derart angepassten sphärisch-astigmatischen Fläche, dass die Prüfwellenfront an jedem Punkt der sphärisch-astigmatischen Fläche im Wesentlichen senkrecht auftrifft, wobei mehrere Messungen durchgeführt werden, bei denen die sphärisch-astigmatische Fläche in mehreren Positionen verkugelt um die beiden astigmatischen Radiusmittelpunkte und/oder um 180° verdreht um eine Flächennormale der sphärisch-astigmatischen Fläche vermessen wird, wobei entsprechende Interferogrammphasen bestimmt werden. Schließlich wird in einem dritten Schritt S3 ein Ermitteln der Wellenfront der Wellenfronterzeugungseinrichtung und einer Oberflächenform der sphärisch-astigmatischen Fläche mittels eines mathematischen Rekonstruktionsverfahrens durchgeführt, wonach die Oberfläche der sphärisch-astigmatischen Fläche 40 mittels einer geeig-

8

neten Bearbeitungsmethode korrigiert wird, wobei die Schritte S1 bis S3 so oft wiederholt werden, bis die Wellenfrontdifferenzen unter einem definierten Schwellwert liegen.

Zusammenfassend werden mit der vorliegenden Erfindung ein Verfahren zum Vermessen einer sphärisch-astigmatischen optischen Fläche vorgeschlagen. Vorteilhaft ist mittels der Erfindung eine hochgenaue Fertigung und Passeprüfung von sphärisch-astigmatischen Flächen, insbesondere von Freiformflächen mit hohem sphärisch-astigmatischem Anteil ermöglicht. Vorteilhaft ist aufgrund des in Teilbereichen scannenden Prinzips die Freiformfläche hochaufgelöst messbar, wobei eine hohe Ortsauflösung und in bestimmten Frequenzbändern eine wesentlich höhere Genauigkeit als mit herkömmlichen Verfahren erreichbar ist. Vorteilhaft lassen sich auf die beschriebene Weise im pm-Bereich genaue Freiformflächen herstellen und vermessen.

Bevorzugt ist vorgesehen, dass für jeden Prüfling ein eigenes Kalibrier-CGH und/oder eine eigene sphärisch-astigmatische Kalibrierfläche gebildet wird. In der Praxis sind auf diese Weise vorteilhaft mehrere optische Komponenten für Objektive mit Freiformflächen exakt prüfbar.

Ausgenutzt wird für die Erfindung die Tatsache, dass die meisten Freiformflächen neben ihrer Grundkrümmung nur noch einen "Grundastigmatismus" und nur schwach ausgeprägte weitere Abweichungsverlaufsanteile aufweisen, wobei für jede einzelne dieser Flächen eine Prüfoptik bestehend aus Erzeugungseinrichtung gebildet wird, wobei eine Referenzkrümmung und ein Referenzastigmatismus einer prüfenden Wellenfront an die Grundform des Prüflings angepasst wird.

## Patentansprüche

1. Verfahren zum Vermessen einer sphärisch-astigmatischen optischen Fläche (40), wobei die sphärisch-astigmatische optische Fläche (40) eine Überlagerung einer Kugelfläche und einer astigmatischen Fläche ist, aufweisend die Schritte:

   a) Generieren einer sphärisch-astigmatischen Wellenfront als Prüfwellenfront mittels einer Wellenfronterzeugungseinrichtung (10);
   b) Interferometrisches Vermessen von Wellenfrontdifferenzen zwischen der von der Wellenfronterzeugungseinrichtung (10) generierten Prüfwellenfront und einer von der sphärisch-astigmatischen Fläche (40) reflektierten Wellenfront, wobei die sphärisch-astigmatische Fläche (40) derart an die Wellenfronterzeugungseinrichtung (10) angepasst ist, dass die Prüfwellenfront an jedem Punkt der sphärisch-astigmatischen Fläche (40) im Wesentlichen senkrecht auftrifft, wobei mehrere Messungen durchgeführt werden, bei denen die sphärisch-astigmatische Fläche (40) in mehreren Positionen verkugelt um die beiden astigmatischen Radiusmittelpunkte und/oder um 180° verdreht um eine Flächennormale der sphärisch-astigmatischen Fläche (40) vermessen wird, wobei entsprechende Interferogrammphasen bestimmt werden; und
   c) Ermitteln der Wellenfront der Wellenfronterzeugungseinrichtung (10) und einer Oberflächenform der sphärisch-astigmatischen Fläche (40) mittels eines mathematischen Rekonstruktionsverfahrens, wonach die Oberfläche der sphärisch-astigmatischen Fläche (40) mittels einer geeigneten Bearbeitungsmethode korrigiert wird, wobei die Schritte a) bis c) so oft wiederholt werden, bis die Wellenfrontdifferenzen unter einem definierten Schwellwert liegen.

2. Verfahren nach Anspruch 1, wobei in Schritt c) die Wellenfront der Wellenfronterzeugungseinrichtung (10) korrigiert wird, wobei die Schritte a) bis c) so oft wiederholt werden, bis die Wellenfrontdifferenzen unter einem definierten Schwellwert liegen.

3. Verfahren nach Anspruch 1 oder 2, wobei die sphärisch-astigmatische Fläche (40) als ein Kalibrierelement (30) für die Wellenfronterzeugungseinrichtung (10) ausgebildet ist.

## Claims

1. Method for measuring a spherical-astigmatic optical area (40), the spherical-astigmatic optical area (40) being the superimposition of a spherical area and an astigmatic area, including the steps of:

   a) generating a spherical-astigmatic wavefront as a test wavefront by means of a wavefront generation device (10) ;
   b) interferometrically measuring wavefront differences between the test wavefront generated by the wavefront generation device (10) and a wavefront reflected by the spherical-astigmatic area (40), the spherical-astigmatic area (40) being adapted to the wavefront generation device (10) in such a way that the test wavefront is incident substantially perpendicularly at each point of the spherical-astigmatic area (40), with a plurality of measurements being carried out, within the scope of which the spherical-astigmatic area (40) is measured at a plurality of positions, spherized about the two centres of the radii of the astigmatism and/or rotated through 180° about a surface normal of the spherical-astigmatic area (40), with corresponding interferogram phases being determined; and

c) ascertaining the wavefront of the wavefront generation device (10) and a surface form of the spherical-astigmatic area (40) by means of a mathematical reconstruction method, according to which the surface of the spherical-astigmatic area (40) is corrected by means of a suitable processing method, with steps a) to c) being repeated until the wavefront differences lie below a defined threshold value.

2. Method according to Claim 1, wherein the wavefront of the wavefront generation device (10) is corrected in step c), with steps a) to c) being repeated until the wavefront differences lie below a defined threshold value.

3. Method according to Claim 1 or 2, wherein the spherical-astigmatic area (40) is in the form of a calibration element (30) for the wavefront generation device (10).

**Revendications**

1. Procédé permettant de mesurer une surface optique (40) sphériquement astigmate, dans lequel la surface optique (40) sphériquement astigmate est une superposition d'une surface sphérique et d'une surface astigmate, présentant les étapes consistant à :

a) générer un front d'onde sphériquement astigmate en tant que front d'onde d'essai au moyen d'un dispositif de génération de front d'onde (10) ;

b) mesurer par interférométrie des différences de front d'onde entre le front d'onde d'essai généré par le dispositif de génération de front d'onde (10) et un front d'onde réfléchi par la surface (40) sphériquement astigmate, dans lequel la surface (40) sphériquement astigmate est adaptée au dispositif de génération de front d'onde (10) de telle sorte que le front d'onde d'essai est en chaque point de la surface (40) sphériquement astigmate incident de manière substantiellement perpendiculaire, dans lequel plusieurs mesures sont effectuées au cours desquelles la surface (40) sphériquement astigmate est mesurée dans plusieurs positions en forme de sphère autour des deux centres de rayon astigmate et/ou en rotation de 180° autour d'une normale à la surface de la surface (40) sphériquement astigmate, dans lequel des phases d'interférogramme correspondantes sont déterminées ; et

c) établir le front d'onde du dispositif de génération de front d'onde (10) et une forme de surface de la surface (40) sphériquement astigmate au moyen d'un procédé de reconstruction mathématique après quoi la surface de la surface (40) sphériquement astigmate est corrigée au moyen d'une méthode de traitement appropriée, les étapes a) à c) étant répétées jusqu'à ce que les différences de front d'onde se situent en-dessous d'une valeur seuil définie.

2. Procédé selon la revendication 1, dans lequel, à l'étape c), le front d'onde du dispositif de génération de front d'onde (10) est corrigé, les étapes a) à c) étant répétées jusqu'à ce que les différences de front d'onde se situent en-dessous d'une valeur seuil définie.

3. Procédé selon la revendication 1 ou 2, dans lequel la surface (40) sphériquement astigmate est réalisée comme un élément d'étalonnage (30) pour le dispositif de génération de front d'onde (10).

SAp          SAp

SAp

SAp

SAp          SAp

SAp

## Fig. 1

180°          180°

## Fig. 2

a)          b)

c)

## Fig. 3

SAp

40

20

Fig. 4

R

11

10

20

30

100

Fig. 5

Fig. 6a

Fig. 6b

Fig. 7

Fig. 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102013226668
- US 7061626 B1
- US 20120229814 A1
- DE 10229816 A1
- US 7538856 B2
- US 7355678 B2

**In der Beschreibung aufgeführte Nicht-Patentliteratur**

- **CLEMENS ELSTER.** Exact two-dimensional wave-front reconstruction from lateral shearing interferograms with large shears. *Applied Optics,* 10. Oktober 2000, vol. 39 (29
- **AUS WIHARDJO E.** Interferometric measurement of actual oblique astigmatism of ophthalmic lenses. *Optical Engineering, Soc. of Photo-Optical Instrumentation Engineers,* 01. Marz 1995, vol. 34 (3), 785-789